# FASCICULE DE BREVET EUROPEEN

(11) **EP 1 243 903 B1**
(45) Date de publication et mention de la délivrance du brevet: **09.09.2009**
(21) Numéro de dépôt: 02290703.4
(22) Date de dépôt: 20.03.2002
(51) Int. Cl.: G01J 5/20

(54) **Détecteurs de rayonnement et procédés pour les fabriquer**
Strahlungsdetektoren und Verfahren zu ihrer Herstellung
Radiation detectors and method of manufacturing the same

(30) Priorité: 21.03.2001 FR 0103820
(43) Date de publication de la demande: 25.09.2002
(73) Titulaire: COMMISSARIAT A L'ENERGIE ATOMIQUE, 75015 Paris (FR)
(72) Inventeur: Vilain, Michel, 38450 Saint-Georges-de-Commiers (FR)
(74) Mandataire: Santarelli

(56) Documents cités:
- EP-A- 0 453 372
- EP-A- 0 566 156
- EP-A- 0 624 900
- DE-A- 19 752 208
- US-A- 5 177 661
- US-A- 5 369 544
- US-A- 5 895 233
- US-A- 5 939 722

## Description

L'invention se rapporte à la fabrication de détecteurs de rayonnement comprenant un ensemble de « microdétecteurs » élémentaires disposés en matrices ou en barrettes. L'invention est particulièrement avantageuse dans le cas où ces microdétecteurs sont des microbolomètres.

Un bolomètre est un dispositif conçu pour transformer le rayonnement auquel il est soumis, habituellement situé dans l'infrarouge, en énergie thermique. L'échauffement résultant du bolomètre cause la variation d'une propriété électrique, par exemple la résistance électrique d'un conducteur connecté à un circuit extérieur au bolomètre. Dans le cas d'un détecteur comprenant une matrice de microbolomètres, ledit circuit électrique, dit « de lecture », prend en charge les fonctions d'adressage matriciel et les stimuli de lecture envoyés à chaque microbolomètre, et convertit les signaux résultants sous un format exploitable pour l'imagerie (par exemple sous forme de signal vidéo). Pour obtenir les meilleures performances possibles, on fait fonctionner les microbolomètres sous une pression de gaz relativement faible (ou sous pression modérée d'un gaz à faible conductivité thermique), afin que la dissipation thermique due à ce gaz soit négligeable devant la conductance thermique intrinsèque des bolomètres.

Les procédés de fabrication classiques de détecteurs de ce type comprennent des étapes initiales réalisées directement à la surface d'un circuit électronique, de manière dite monolithique (c'est-à-dire dans une séquence continue d'opérations sur le même substrat, habituellement de silicium) ou hybride (avec report sur un substrat d'éléments préfabriqués). Ces étapes font intervenir des techniques usuelles de l'industrie microélectronique, notamment des techniques de fabrication collective, concernant habituellement quelques dizaines à quelques centaines de détecteurs disposés sur un même substrat (« *wafer level* » en anglais). Au cours de ces étapes initiales, on met en place les organes proprement bolométriques (absorption optique, résistance variable avec la température) à la surface d'une couche « sacrificielle », en ce sens que cette couche (ordinairement faite de polyimide, de silicium polycristallin, ou de métal tel que du cuivre ou de l'aluminium) est éliminée en fin de processus (par combustion dans un plasma d'oxygène par exemple), de manière à laisser les structures du bolomètre suspendues au-dessus du substrat.

A la suite de ces étapes initiales, on pratique un test et un tri de qualité automatisés, puis l'assemblage est découpé en détecteurs individuels. Le processus de fabrication se termine par une séquence d'opérations dites « unitaires », c'est-à-dire pratiquées sur chaque détecteur individuellement.

Ces opérations unitaires comprennent classiquement les étapes suivantes.

La première étape est la « libération » des microbolomètres, qui consiste à éliminer une partie au moins des couches sacrificielles. Cette opération conduit à une extrême vulnérabilité mécanique des structures. De plus, la moindre contamination par des poussières (contamination dite « particulaire ») de dimension supérieure à quelques micromètres dégrade également le détecteur localement, car le nettoyage est exclu, de quelque manière que ce soit, sous peine de destruction complète : les microbolomètres libérés ne supportent en effet ni soufflage, ni mouillage, ni contact.

Ensuite, l'on colle ou soude chaque détecteur sur une embase (en anglais, *« die carrier»)* de céramique, cette embase étant elle-même habituellement collée ou soudée sur un système de régulation thermique (élément Peltier), et l'on connecte le détecteur par des fils électriques (en anglais, « *wire bonding »).* Cet ensemble est ensuite reporté dans un boîtier comprenant deux parties au moins : une embase métallique ou céramique, et un capot comportant une fenêtre transparente aux rayonnements infrarouges. Avant scellement dudit capot, les entrées et sorties électriques du boîtier sont connectées aux pistes métalliques de la céramique, de nouveau par « *wire bonding* ». L'assemblage et le nombre d'opérations peut être optimisé, mais comme on le voit, l'ensemble reste très complexe.

Enfin, pour les systèmes les plus performants, on dispose à l'intérieur du boîtier, avant de sceller le capot, un « getter » constitué d'une matière connue pour sa capacité à améliorer la qualité du vide (par exemple du fer, du titane, du vanadium, du cobalt, de l'aluminium, du zirconium ou du manganèse, ou un alliage des mêmes métaux).

Toutes ces opérations unitaires, associées au coût de fourniture des éléments et composants constituant le boîtier, ont pour effet un coût de fabrication additionnel qui est nettement supérieur au coût de la fabrication collective des détecteurs. Ce coût de fin de fabrication (après les opérations collectives) est particulièrement élevé dans le cas des systèmes d'imagerie à microbolomètres (il atteint ordinairement 60 à 70 % du coût du composant final), car le niveau de pression résiduelle requis pour un fonctionnement optimal du détecteur (classiquement de l'ordre de 10⁻² mbar) nécessite une qualité de scellement sous vide élevée. Ceci justifie la mise en oeuvre de techniques unitaires élaborées sur des boîtiers spécifiques (utilisation d'évents ou queusots de pompage), et un cycle de dégazage et activation du getter relativement long (plusieurs heures). Par ailleurs, les opérations de test et de tri des produits en cours et/ou en fin de fabrication sont elles-mêmes unitaires, et très difficiles à automatiser.

On voit donc, concernant la fabrication de détecteurs comprenant des matrices de microbolomètres, que les techniques classiques souffrent d'un débit de production faible, et d'un coût global élevé.

Un exemple de procédé de fabrication mettant en oeuvre deux substrats est donné dans le brevet EP 566 156 (fig. 10).

Le brevet US - 5 895 233 a précisément pour but d'améliorer l'état de la technique dans ce domaine. Ce document propose une technique collective pour l'élaboration de capots sur des substrats de format classique qu'on appellera « substrats fenêtre », et une technique également collective de scellement de chaque substrat fenêtre sur un « substrat détecteur », les deux substrats étant maintenus à une certaine distance l'un de l'autre au moyen de perlures de brasage de manière à assurer la protection mécanique sous vide du détecteur.

Cette technique présente plusieurs inconvénients. En premier lieu, la soudure du capot sur le substrat détecteur est difficile à maîtriser. En outre, la réalisation du vide nécessite l'utilisation de getters de grandes dimensions si l'on utilise un équipement de soudure ordinaire, ou alors un équipement de soudure sous vide de haute technologie. D'autre part, cette technique impose l'utilisation de matériaux relativement épais (plusieurs centaines de micromètres) pour réaliser le « substrat fenêtre », ce qui en limite la transparence optique, et donc les performances du détecteur. Un autre inconvénient est que les perlures de brasage occupent une surface importante du substrat détecteur, ce qui fait que seuls les détecteurs de larges dimensions peuvent être économiquement intéressants ; mais dans le cas de grands détecteurs, on constate une flexion des deux parties du boîtier sous l'effet de la pression atmosphérique extérieure, ce qui provoque des aberrations géométriques, et peut même amener la fenêtre à venir en contact avec les microbolomètres, auquel cas le détecteur est détruit ; pour pallier ce problème, le document propose de disposer un pilier à l'intérieur du boîtier, mais cela implique qu'une partie du détecteur est rendue aveugle.

Pour résoudre ces problèmes, l'invention propose un procédé de fabrication de détecteurs de rayonnement, dans lequel ces détecteurs comprennent chacun un assemblage de microdétecteurs, par exemple des microbolomètres, sous une fenêtre transparente audit rayonnement, ledit procédé étant remarquable en ce que lesdits détecteurs sont fabriqués collectivement sur un substrat, et en ce qu'il comprend notamment les étapes suivantes :
- la construction de plusieurs couches dont, pour chacun desdits détecteurs, au moins une couche transparente audit rayonnement et servant de fenêtre, et
- l'élimination partielle desdites couches principalement sous ladite couche transparente, de sorte que lesdits microdétecteurs se retrouvent placés, pour chacun desdits détecteurs, dans une ou plusieurs cavités, qui sont ensuite mises sous vide ou sous faible pression.
   Ainsi, les détecteurs selon l'invention comportent, de par leur construction même, les éléments propres au maintien sous vide des microdétecteurs. Avantageusement, cette construction selon l'invention peut utiliser des techniques de la « microélectronique », c'est-à-dire l'ensemble des techniques de micro-usinage telles que le dépôt et la gravure de couches.
   Selon des caractéristiques particulières, lesdites étapes de construction et d'élimination partielle de couches conduisent à la formation d'une cloison périphérique entourant chacun desdits détecteurs.
   Ainsi, quel que soit le format de détecteur choisi, il n'y aura aucune perte d'espace latéral sur sa périphérie pour obtenir un composant terminé et protégé. Le procédé selon l'invention est donc aussi économiquement intéressant pour de petits détecteurs que pour des détecteurs de grandes dimensions.
   Selon des caractéristiques particulières, ladite étape d'élimination partielle de couches est effectuée au travers d'une ou plusieurs ouvertures pratiquées dans l'enveloppe de chacun desdits détecteurs. De préférence, lesdites ouvertures seront pratiquées dans ladite couche transparente, afin de faciliter l'aménagement de ces ouvertures.
   Grâce à ces dispositions, la construction desdites cavités contenant les microdétecteurs est particulièrement simple, et ne fait appel qu'à des techniques classiques de microélectronique.
   De préférence, ladite étape consistant à mettre lesdites cavités sous vide ou sous faible pression sera effectuée au travers desdites ouvertures ; de plus, on prévoira l'élaboration à l'intérieur des cavités, au cours desdites étapes de construction et d'élimination partielle de couches, en regard de chacune desdites ouvertures, d'une surface servant de support à un matériau apte à boucher lesdites ouvertures afin de sceller lesdites cavités.
   Grâce à ces dispositions, les « bouchons » sont maintenus en place, et l'on évite la diffusion dudit matériau de scellement à l'intérieur des cavités.
   L'invention concerne aussi divers dispositifs.
   Elle concerne ainsi, premièrement, un détecteur de rayonnement fabriqué au moyen de l'un des procédés décrits succinctement ci-dessus.
   L'invention concerne, deuxièmement, un détecteur de rayonnement comprenant un assemblage de microdétecteurs, par exemple des microbolomètres, ledit détecteur étant remarquable en ce qu'il comprend également
- une portion de substrat,
- une cloison périphérique entourant ledit détecteur et solidaire de ladite portion de substrat, et
- une paroi adaptée à servir de fenêtre pour ledit rayonnement et solidaire de ladite cloison périphérique,
ladite portion de substrat, ladite cloison périphérique et ladite paroi formant une enveloppe pour ledit détecteur, à l'intérieur de laquelle se trouvent une ou plusieurs cavités contenant lesdits microdétecteurs sous vide ou sous faible pression.

L'invention concerne, troisièmement, un détecteur de rayonnement comprenant un assemblage de microdétecteurs, par exemple des microbolomètres, placés sous vide ou sous faible pression dans une ou plusieurs cavités situées à l'intérieur de l'enveloppe dudit détecteur, ledit détecteur étant remarquable en ce que ladite enveloppe comprend
- une portion de substrat, et
- une paroi adaptée à servir de fenêtre pour ledit rayonnement, et en ce que ladite enveloppe présente une ou plusieurs ouvertures bouchées à l'aide d'un matériau adéquat.

On notera que les dispositifs selon l'invention peuvent être intégralement fabriqués à l'aide de techniques relevant de la microélectronique, c'est-à-dire dans des milieux très peu générateurs de particules polluantes, et que, de plus, le dispositif terminé peut être nettoyé par des techniques conventionnelles en cas de besoin, au cours ou après les opérations terminales de soudure des connexions, ou de soudure et collage sur le support définitif. Le rendement de fabrication est de ce fait élevé.

Selon des caractéristiques particulières, le détecteur de rayonnement comprend, d'une part, une cloison périphérique, et, d'autre part, soit un réseau de cloisons, soit un réseau de piliers internes, ladite fenêtre étant solidaire de cette cloison périphérique et de ces cloisons ou piliers internes.

Grâce à ces dispositions, il n'est pas nécessaire de modifier la technique de réalisation pour l'adapter au format du détecteur, comme c'était le cas dans l'art antérieur utilisant un capot. L'effort mécanique dû à la pression atmosphérique est compensé par les cloisons et/ou piliers internes, indépendamment du format du détecteur.

D'autre part, la fenêtre peut être de faible épaisseur, ce qui conduit naturellement à une grande transparence optique, favorable à des performances optimales.

Selon des caractéristiques particulières, on couvre certaines surfaces internes choisies des cavités au moyen d'un getter.

Il peut en effet s'avérer utile d'améliorer ainsi la durabilité du vide intérieur, qui est nécessaire au maintien des caractéristiques optimales des bolomètres. Bien que la technique de réalisation et de scellement des cavités selon l'invention permette d'obtenir un niveau de vide suffisant sans faire usage de getters, l'homme de l'art pourra estimer dans certaines circonstances que, compte tenu des spécifications qu'il vise (notamment concernant la durée de vie des microdétecteurs), le rapport surface/volume des cavités ainsi obtenu est trop élevé.

Une fois la fabrication achevée conformément à ces dispositions, l'assemblage est soumis à des opérations de test électro-optique et de tri automatiques, puis il est découpé en puces (« *chip »* en anglais) individuelles.

On notera à cet égard qu'il est possible, grâce à l'invention, de mettre en oeuvre ces opérations de manière automatisée, directement sur le substrat entier (« *wafer* level ») et avant découpe des détecteurs individuels ; cela est très avantageux par rapport aux procédés classiques, où ces opérations de test sont pratiquées sur des détecteurs individuels intégrés dans des boîtiers. On élimine ainsi toutes les opérations unitaires selon l'art antérieur décrites ci-dessus. L'invention permet donc de réaliser des économies considérables.

Le détecteur peut être utilisé tel quel, comme n'importe quelle puce microélectronique à ce stade d'élaboration. Il est alors virtuellement possible d'appliquer toutes les méthodes d'intégration dans des systèmes plus complexes en usage dans l'industrie, pourvu que les agressions mécaniques et chimiques au cours du processus et de la mise en oeuvre soient compatibles avec la relative vulnérabilité mécanique superficielle du détecteur au niveau de la surface optique.

Lesdites puces individuelles peuvent être traitées de diverses manières.

Selon une première utilisation des puces selon l'invention, celles-ci sont intégrées directement sur leur site final de mise en oeuvre (« puces nues »).

Il faudra toutefois veiller ici à ce que le composant soit traité de manière compatible avec sa relative fragilité, laquelle dépend de la nature et de l'épaisseur de la fenêtre ainsi que du pas de répétition des cloisons ou piliers internes ; en effet, plus le pas sera faible, et moins la puce sera vulnérable au niveau de la fenêtre, à épaisseur constante de cette fenêtre.

Selon une utilisation différente des détecteurs selon l'invention, ceux-ci sont intégrées par soudure ou collage dans un boîtier muni d'une fenêtre transparente au rayonnement que l'on cherche à détecter (et muni éventuellement de modules Peltier pour la stabilisation thermique). Ce boîtier est ensuite utilisé comme tout boîtier de dispositif classique destiné à la détection de rayonnement.

Bien que l'utilisation de boîtiers individuels implique un coût supplémentaire (en échange d'une protection accrue des puces), on notera que ces boîtiers n'ont nul besoin de spécifications d'étanchéité particulièrement sévères, comme c'était le cas dans l'état de l'art. Les spécifications habituelles des boîtiers pour imagerie visible, déjà largement répandus et donc relativement bon marché, sont adéquates. Il suffit de spécifier une fenêtre transparente aux longueurs d'onde à détecter.

Enfin, l'invention vise divers appareils d'observation ou de mesure incorporant au moins un détecteur de rayonnement tel que ceux décrits succinctement ci-dessus. Ces appareils peuvent par exemple être des systèmes d'imagerie opérant dans l'infrarouge.

D'autres aspects et avantages de l'invention apparaîtront à la lecture de la description détaillée, que l'on trouvera ci-dessous, de modes particuliers de réalisation donnés à titre d'exemples non limitatifs. Cette description se réfère aux dessins annexés, dans lesquels :
- la figure 1a est une vue de dessus de l'assemblage obtenu après une première étape dans la fabrication collective de détecteurs, étape commune à l'invention et à l'art antérieur,
- la figure 1b est une vue en coupe selon AA de l'assemblage illustré sur la figure 1a,
- la figure 2a est une vue de dessus de l'assemblage obtenu après une deuxième étape dans la fabrication de détecteurs selon un premier mode de réalisation de l'invention,
- la figure 2b est une vue en coupe selon AA de l'assemblage illustré sur la figure 2a,
- la figure 3a est une vue de dessus de l'assemblage obtenu après une troisième étape dans la fabrication de détecteurs selon le premier mode de réalisation de l'invention,
- la figure 3b est une vue en coupe selon AA de l'assemblage illustré sur la figure 3a,
- la figure 4a est une vue de dessus de l'assemblage obtenu après une quatrième étape dans la fabrication de détecteurs selon le premier mode de réalisation de l'invention,
- la figure 4b est une vue en coupe selon AA de l'assemblage illustré sur la figure 4a,
- la figure 5a est une vue de dessus de l'assemblage obtenu après une cinquième étape dans la fabrication de détecteurs selon le premier mode de réalisation de l'invention,
- la figure 5b est une vue en coupe selon AA de l'assemblage illustré sur la figure 5a,
- la figure 6a est une vue de dessus de l'assemblage obtenu après une sixième et dernière étape dans la fabrication de détecteurs selon le premier mode de réalisation de l'invention,
- la figure 6b est une vue en coupe selon AA de l'assemblage illustré sur la figure 6a,
- la figure 7 représente un substrat 1 sur lequel on a construit un certain nombre de détecteurs selon le premier mode de réalisation de l'invention,
- la figure 8 est une vue en coupe schématique d'un détecteur selon le premier mode de réalisation de l'invention,
- la figure 9a est une vue de dessus de l'assemblage selon le premier mode de réalisation de l'invention, illustrant une variante faisant usage de « getters »,
- la figure 9b est une vue en coupe selon AA de l'assemblage illustré sur la figure 9a,
- la figure 10 est une vue en coupe de l'assemblage selon le premier mode de réalisation de l'invention, illustrant une autre variante faisant usage de « getters »,
- la figure 11a est une vue de dessus de l'assemblage obtenu après une deuxième étape dans la fabrication de détecteurs selon un deuxième mode de réalisation de l'invention,
- la figure 11b est une vue en coupe selon AA de l'assemblage illustré sur la figure 11a,
- la figure 12a est une vue de dessus de l'assemblage obtenu après une troisième étape dans la fabrication de détecteurs selon le deuxième mode de réalisation de l'invention,
- la figure 12b est une vue en coupe selon AA de l'assemblage illustré sur la figure 12a,
- la figure 13a est une vue de dessus de l'assemblage obtenu après une quatrième étape dans la fabrication de détecteurs selon le deuxième mode de réalisation de l'invention,
- la figure 13b est une vue en coupe selon AA de l'assemblage illustré sur la figure 13a,
- la figure 14a est une vue de dessus de l'assemblage obtenu après une cinquième étape dans la fabrication de détecteurs selon le deuxième mode de réalisation de l'invention,
- la figure 14b est une vue en coupe selon AA de l'assemblage illustré sur la figure 14a,
- la figure 15a est une vue de dessus de l'assemblage obtenu après une sixième et dernière étape dans la fabrication de détecteurs selon le deuxième mode de réalisation de l'invention,
- la figure 15b est une vue en coupe selon AA de l'assemblage illustré sur la figure 15a,
- la figure 16 représente un substrat 1 sur lequel on a construit un certain nombre de détecteurs selon le deuxième mode de réalisation de l'invention,
- la figure 17a est une vue en perspective schématique d'un détecteur selon l'invention,
- la figure 17b est une vue en coupe schématique d'un détecteur selon l'invention,
- la figure 18a est une vue de dessus de l'assemblage selon le deuxième mode de réalisation de l'invention, illustrant une variante faisant usage de « getters »,
- la figure 18b est une vue en coupe selon AA de l'assemblage illustré sur la figure 18a, et
- la figure 19 est une vue en coupe de l'assemblage selon le deuxième mode de réalisation de l'invention, illustrant une autre variante faisant usage de « getters ».

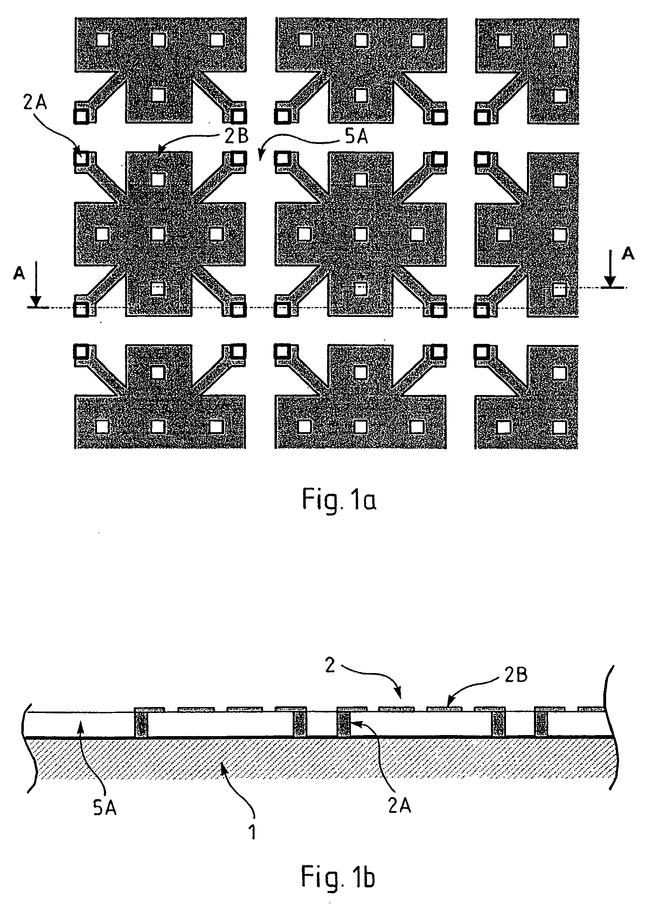

Les **figures 1a et 1b** présentent respectivement une vue de dessus et une coupe locale de l'assemblage dans un état de configuration et d'élaboration compatible avec l'application de l'invention.

Au départ, on dispose, dans un substrat 1, des circuits électroniques (non représentés) aptes à fournir, d'une part, les stimuli de lecture de microbolomètres 2, et d'autre part le traitement du signal résultant de l'éclairement de ces microbolomètres 2 à travers une optique adaptée.

Les microbolomètres 2 sont disposés classiquement de manière à former une matrice ou une barrette. La dimension habituelle d'un bolomètre élémentaire 2 dans chaque direction parallèle au substrat 1 est ordinairement de l'ordre de 20 à 50 µm. Il n'est pas nécessaire dans le cadre de cette invention de détailler la fabrication de ces éléments. On observera simplement qu'ils sont habituellement réalisés à l'aide de parties à extension essentiellement verticale 2A (piliers ou structures apparentées) destinées à maintenir les parties supérieures 2B séparées du substrat 1, pour des raisons d'isolation thermique, et accessoirement d'optimisation optique. La partie 2B contient les structures de détection infrarouge.

Comme mentionné en introduction, ces parties 2B sont habituellement élaborées à la surface d'une couche « sacrificielle » 5A. Grâce à ce procédé d'élaboration, on peut maintenir l'espacement entre deux bolomètres voisins à une cote minimale, de manière à permettre leur séparation physique et électrique avec un taux de remplissage (« *fill factor »* en anglais) maximal.

Toutefois, les détails de structure des bolomètres 2 représentés sur les figures ne sont pas particuliers à l'invention, et ne sont présentés qu'à titre d'exemple ; en particulier, on supposera pour simplifier la présente description que chaque microbolomètre ne présente aucune partie commune avec les microbolomètres voisins. Dans les autres cas, l'homme du métier saura adapter les étapes de fabrication en faisant usage de ses capacités ordinaires.

On supposera le procédé de fabrication accompli jusqu'à l'instant où ladite couche 5A pourrait être éliminée suivant l'art habituel. Mais, selon l'invention, cette couche sera conservée pendant un certain nombre d'étapes du procédé de fabrication.

On va décrire à présent les étapes essentielles subséquentes dans la fabrication de détecteurs selon un premier mode de réalisation de l'invention.

Les opérations formant donc une deuxième étape de ce mode de réalisation sont les suivantes.

On dépose d'abord par des moyens traditionnels une seconde couche sacrificielle 5B, d'un matériau de préférence identique, ou du moins analogue à celui de la couche 5A. On emploiera de préférence du polyimide, qui sera recuit de manière habituelle pour supporter la suite du processus. L'épaisseur de cette couche sera de préférence de l'ordre de 1 à 3 µm.

Puis l'on grave, de manière essentiellement verticale de préférence, cette couche 5B et la couche sous-jacente 5A par des moyens traditionnels de gravure ionique réactive (en anglais, « *Reactive Ionic Etching »,* ou « RIE »), à l'aide d'un premier masque lithographique 6.

Il peut être avantageux, pour faciliter l'assemblage, d'utiliser un contre-masque (« *hard mask* » en anglais) (non représenté), constitué habituellement d'une couche d'aluminium, ou d'oxyde de silicium SiO₂ ou encore de nitrure de silicium Si₃N₄, déposée suivant une méthode adaptée à chaque matériau. Cette technique connue facilite la réalisation de gravures essentiellement verticales, qui permettent de limiter avantageusement la largeur des rainures obtenues après gravure à des valeurs habituellement comprises entre 0,5 et 2 µm. Ce contre-masque pourra avantageusement être laissé en surface de la couche 5B pour la suite des opérations.

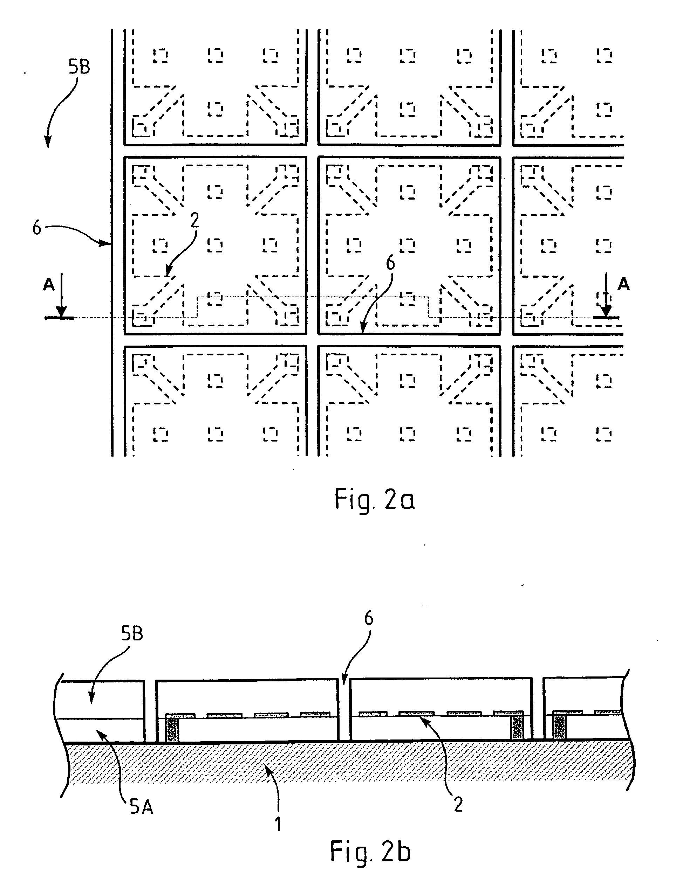

Les **figures 2a et 2b** présentent respectivement une vue de dessus et une coupe locale de l'assemblage, après élimination du masque lithographique (et, le cas échéant, du contre-masque).

On dépose ensuite sur l'ensemble de la structure une couche 3 constituée d'un matériau minéral (métallique ou diélectrique) tel que le titane, le nitrure de titane, le tungstène, le siliciure de tungstène, l'oxyde de silicium SiO₂, le nitrure de silicium Si₃N₄, ou le silicium amorphe. L'épaisseur (de préférence entre 0,1 et 1 µm) et la nature de ce matériau, ainsi que le procédé de dépôt (par exemple, le Dépôt Chimique en Phase Vapeur à Basse Pression, en anglais *« Low Pressure Chemical Vapor Déposition* »), seront choisis de manière à remplir au mieux les rainures. On peut aussi employer un empilement de plusieurs couches de natures différentes.

Le masque 6 comprendra de préférence au moins une ouverture linéaire continue et fermée sur elle-même, de façon à dessiner les limites périphériques de zones destinées à constituer des détecteurs 100. La gravure de la couche 5B sera poursuivie à travers la couche 5A, de telle manière que ce motif périphérique produise une rainure débouchant en surface du substrat 1.

On passe ensuite à la troisième étape de fabrication.

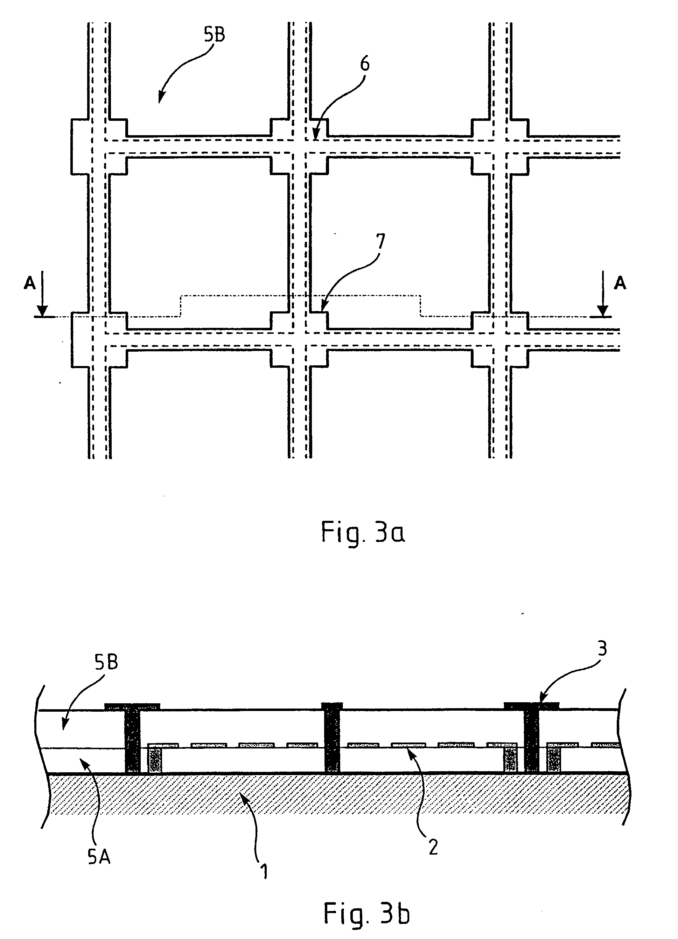

On grave d'abord la couche 3 à l'aide d'un second masque lithographique 7, suivant un contour tel que celui représenté sur la **figure 3a****.**

Après gravure, le motif résiduel recouvre de préférence toutes les rainures réalisées à l'étape précédente, et réserve des surfaces d'extension réduite (par rapport à la surface d'un microbolomètre). Ces surfaces seront avantageusement réservées à l'aplomb de zones non optiquement sensibles de chaque microbolomètre, comme le montre la **figure 3b**, de façon à ne pas masquer les zones optiquement sensibles.

Au delà de la périphérie du détecteur 100, la couche 3 sera de préférence éliminée par gravure, comme représenté.

Si le contre-masque de l'étape précédente a été conservé, il en résulte un arrêt plus facile de la gravure de la couche 3 sur la couche 5B. On terminera alors cette troisième étape par la gravure auto-alignée de ce contre-masque, afin de dégager la surface de la couche 5B.

On passe ensuite à la quatrième étape de fabrication.

On dépose une troisième couche sacrificielle 5C, d'un matériau de préférence identique, ou du moins analogue à celui des couches 5A et 5B, de préférence du polyimide, qui sera également recuit de manière habituelle pour supporter la suite du processus. L'épaisseur de cette couche sera de préférence de l'ordre de 0,2 à 1 µm.

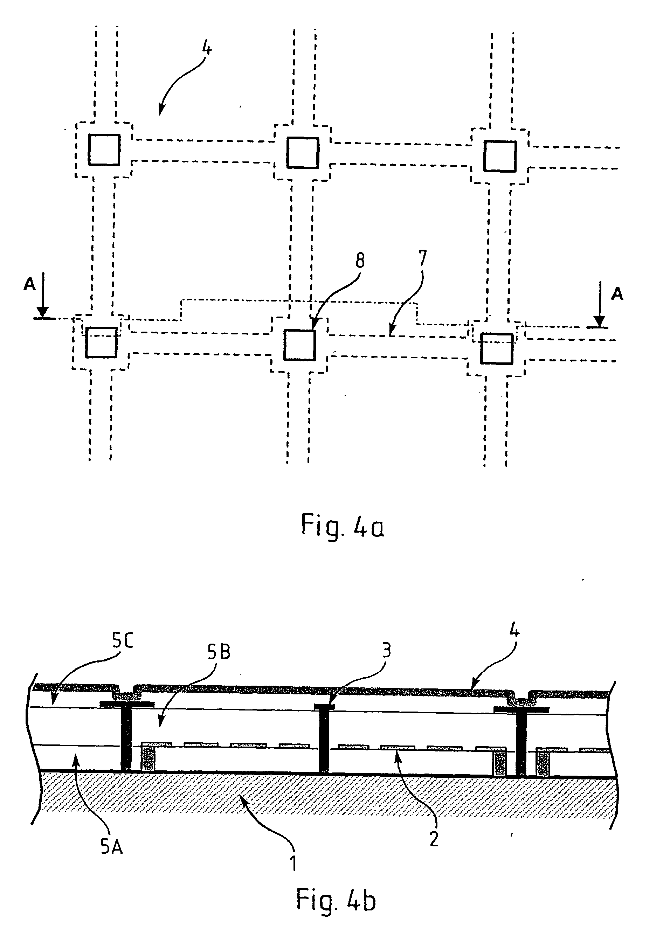

Puis l'on grave cette couche 5C, par des moyens traditionnels de gravure ionique réactive (RIE), à l'aide d'un troisième masque lithographique 8, dont le contour est représenté sur la **figure 4a****.**

Après élimination du masque lithographique, on dépose une fenêtre 4 en surface de la couche 5C, comme indiqué sur la f**igure 4b**. Les surfaces définies par le masque 8 constituent les points d'appui temporaires de la fenêtre sur la structure.

On remarquera que ces points d'appui peuvent être très nombreux par unité de surface sans perte de qualité du détecteur, pourvu que leur disposition soit judicieusement choisie. Ces points d'appui seront avantageusement disposés de manière régulière et rapprochée (par exemple un par bolomètre, comme représenté sur la figure 4a).

Les matières constituant la fenêtre 4 seront bien entendu choisies transparentes aux rayonnements à détecter par les bolomètres disposés au-dessous. On considérera aussi la possibilité d'employer des couches anti-reflet sur une, ou les deux faces de cet élément. On retiendra par exemple une couche principale de silicium amorphe (indice de réfraction proche de 4 dans l'infrarouge) associée à deux couches (au-dessous et au-dessus) de nitrure de silicium Si₃N₄ (indice proche de 2). En ajustant l'épaisseur de ces diverses couches de manière judicieuse, on obtiendra une fenêtre pratiquement transparente pour des longueurs d'onde comprises entre 8 et 14 µm environ. L'épaisseur totale de la fenêtre 4 sera de préférence comprise entre environ 0,1 µm et quelques µm.

On peut aussi optimiser le dispositif de manière avantageuse en disposant la fenêtre 4 à une altitude judicieusement choisie au-dessus du plan du microbolomètre 2, afin d'améliorer l'énergie captée par ce dernier grâce aux ondes stationnaires crées dans la cavité supérieure, entre le bolomètre et la fenêtre. Cet ajustement s'obtient en jouant sur les épaisseurs des couches 5B et 5C.

On passe ensuite à la cinquième étape de fabrication.

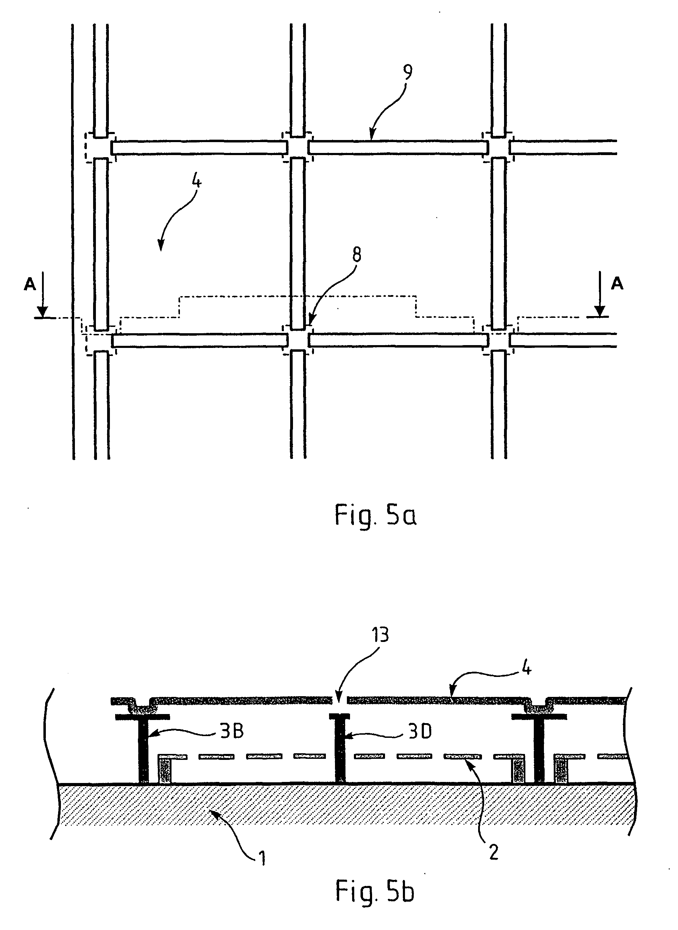

On grave la fenêtre 4 de manière connue, à l'aide d'un quatrième masque lithographique 9 représenté sur la **figure 5a**. La couche 4 sera de préférence éliminée au-delà des limites du détecteur 100.

Comme le montre la **figure 5b**, ce masque 9 protège la fenêtre 4 sur l'essentiel de sa surface, pénètre légèrement à l'intérieur des zones de contact (obtenues précédemment à l'aide du masque 8) entre les couches 3 et 4, et définit de préférence des ouvertures 13 joignant ces zones de contact.

On élimine ensuite toutes les couches sacrificielles de polyimide 5A, 5B et 5C, par exemple à l'aide d'un traitement sous plasma d'oxygène, suivant les techniques bien connues de l'homme de l'art.

On notera que chaque microbolomètre 2 est à présent entouré par des cloisons 3D et le cas échéant des cloisons 3B situées à la périphérie du détecteur 100, toutes ces cloisons étant solidaires du substrat 1.

Les rainures pratiquées précédemment à l'aide du masque 9 relient le milieu extérieur aux structures contenues dans les cavités définies entre la surface du substrat 1, les cloisons 3D et 3B, et la fenêtre 4, comme le montre la figure 5b.

On passe ensuite à la sixième et dernière étape de fabrication.

On applique d'abord un traitement thermique sous vide, meilleur que 10⁻⁵ mbar de préférence, dans une enceinte adaptée, à une température aussi élevée que possible compte tenu des matériaux en place à cet instant, pendant une durée permettant le dégazage de l'ensemble des surfaces de l'assemblage : substrat, microbolomètres, cloisons, fenêtre.

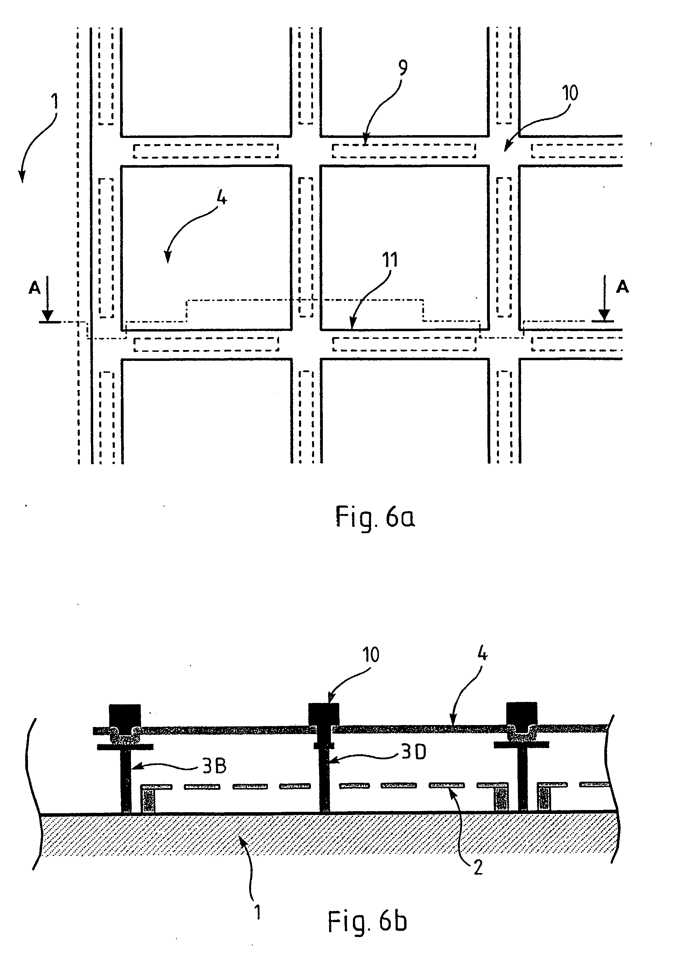

Avant remontée de pression pour retour à l'atmosphère de l'enceinte sous vide, on dépose une couche 10, de préférence métallique (par exemple en aluminium), d'épaisseur suffisante pour sceller de manière hermétique les ouvertures 13 pratiquées à l'aide du masque 9, comme le montrent les **figures 6a et 6b**. Pour cette raison, l'espace entre la surface supérieure de la couche 3, qui sert de support au « bouchon », et la surface inférieure de la fenêtre 4 doit être relativement faible. Cet espace est défini par l'épaisseur de la couche 5C. Le recouvrement des motifs 9 et 7 évite la pénétration des matières métalliques à l'intérieur des cavités. Le dépôt de cette couche 10 sera réalisé de préférence par évaporation, selon des techniques connues (voir par exemple "Vacuum Sealing of Microcavities using Metal Evaporation", par M. Bartek *et al.*, Sensors and Actuators A61, pages 364 à 368, 1997).

En outre, avant remontée de pression, et avant le scellement des cavités, on pourra avantageusement introduire un gaz à faible conductivité thermique, par exemple du xénon, sous faible pression. Cela permet de modérer les spécifications de taux de remontée de pression au cours du temps, au prix d'une perte modérée de performance.

Les assemblages peuvent alors être remis à l'atmosphère, afin de procéder à l'opération finale, alors que les cavités restent sous vide et sont protégées du milieu extérieur.

La gamme d'épaisseurs proposée pour la fenêtre 4 (entre environ 0,1 µm et quelques µm) est suffisante pour contenir les effets de la pression atmosphérique extérieure, lorsque le processus technologique est achevé. En effet, la densité des points d'appui 3D et 3B est telle que la déformation résultante de la fenêtre 4 entre deux points d'appui est négligeable, et ceci d'autant plus que le pas matriciel de répétition des points d'appui est petit.

On terminera cette série d'étapes par la gravure, réalisée de manière connue, de la couche 10 en dehors des zones de scellement, à l'aide d'un cinquième masque lithographique 11. L'aluminium sera très facilement gravé par chimie acide par exemple.

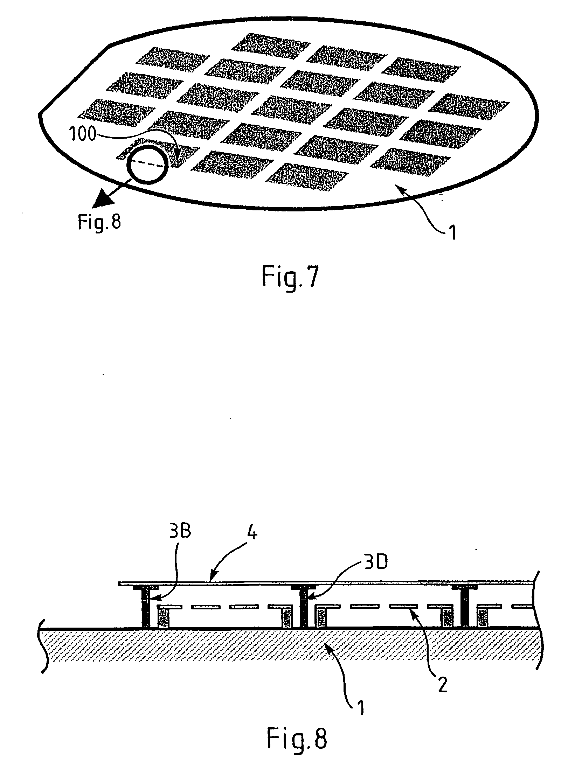

La **figure 7** représente un substrat 1 sur lequel on a construit un certain nombre de détecteurs 100 en suivant les étapes décrites ci-dessus.

La **figure 8** est une vue en coupe d'un détecteur 100 selon l'invention, prise selon un plan perpendiculaire au substrat 1. La coupe représente un bord du détecteur, de manière à illustrer entre autres la structure correspondante.

La fenêtre 4 s'appuie sur les cloisons 3D et 3B dont elle est solidaire. Le volume compris entre le substrat 1, la cloison périphérique 3B et la fenêtre 4 est isolé de manière hermétique du milieu extérieur. De plus, chaque cavité est isolée des cavités adjacentes.

Sur la figure 8, chaque cavité contient un seul microbolomètre 2. Cependant, en fonction des applications envisagées pour les détecteurs 100, on pourra naturellement prévoir de mettre en place les cloisons 3D de manière à ce que certaines au moins des cavités contiennent plusieurs microbolomètres 2.

Le premier mode de réalisation de l'invention étant ainsi défini dans ses étapes essentielles, il est clair que l'homme du métier pourra y apporter divers perfectionnements ou adaptations en fonction des besoins pratiques.

Notamment, on pourra améliorer si nécessaire la durabilité du vide intérieur en prévoyant de couvrir certaines surfaces internes des cavités au moyen d'un getter classique 12 déposé par des moyens conventionnels.

On peut par exemple, lors de la réalisation des microbolomètres, couvrir d'une telle matière une partie de la surface du substrat 1, à l'intérieur de la cavité et au voisinage immédiat de certains au moins des microbolomètres 2. Si cette disposition est susceptible de perturber les caractéristiques de qualité (optiques en particulier) des bolomètres, on disposera de préférence ces surfaces sur des zones partiellement ou totalement inactives optiquement, par exemple près des bras d'isolation thermique des bolomètres.

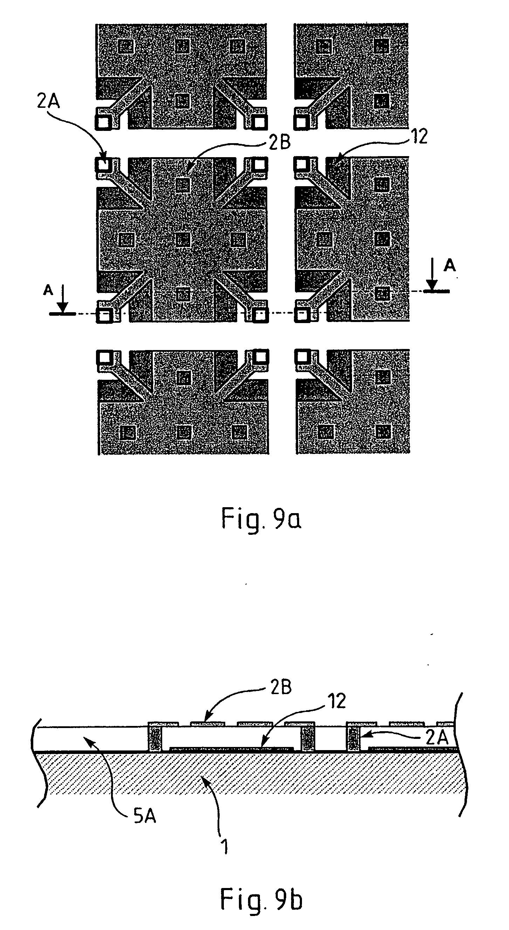

Une deuxième variante, illustrée sur les **figures 9a et 9b**, consiste à disposer ces getters sur la quasi-totalité de la surface du substrat incluse dans chaque cavité. Cette disposition est notamment avantageuse quand le coefficient de réflexion de ces éléments dans l'infrarouge est élevé, comme c'est ordinairement le cas pour les métaux, y compris ceux qui constitueront le getter, à des degrés variables. En effet, l'utilisation de réflecteurs à infrarouge dans les détecteurs à microbolomètres est bien connue ; cette variante de l'invention permet d'utiliser les getters comme réflecteurs, en plus de leur fonction d'amélioration du vide.

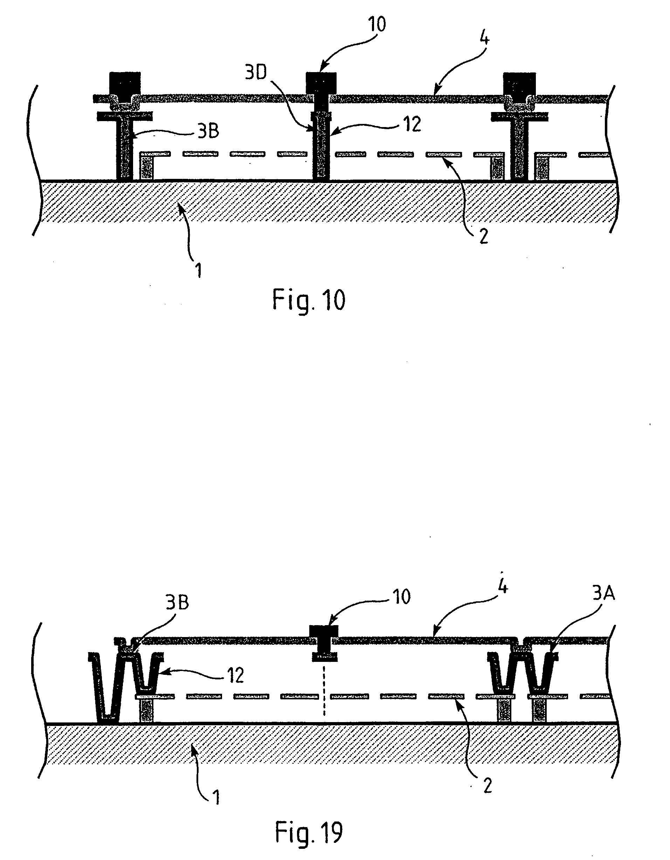

Une troisième variante, illustrée schématiquement sur la **figure 10**, consiste en la disposition de getters sur une partie au moins des cloisons 3D et 3B. Cette disposition permet de dissocier la fonction « réflecteur » de la fonction « getter », c'est-à-dire de les optimiser séparément. Selon cette disposition, les cloisons 3D et 3B sont constituées d'une première couche de getter, qui viendra tapisser les surfaces verticales et horizontales, puis éventuellement d'autres couches finales destinées à améliorer la géométrie, ou la résistance mécanique, ou l'étanchéité des cloisons, ou plusieurs de ces caractères simultanément.

Ces variantes, en particulier les deux dernières, permettent d'assurer un rapport surface de getter/surface totale de cavité favorable au maintien d'un vide de bonne qualité, même pour les très petits volumes considérés.

On va décrire à présent les étapes essentielles dans la fabrication de détecteurs selon un deuxième mode de réalisation de l'invention.

La première étape étant, comme on l'a dit, la même pour l'invention et pour l'art antérieur, on commencera tout de suite par décrire la deuxième étape.

Comme dans le premier mode de réalisation, on dépose d'abord une seconde couche sacrificielle 5B, d'un matériau de préférence identique, ou du moins analogue à celui de la couche 5A. On emploiera de préférence du polyimide, qui sera recuit de manière habituelle pour supporter la suite du processus. L'épaisseur de cette couche sera de préférence de l'ordre de 1 à 3 µm.

Puis l'on grave, de manière essentiellement verticale de préférence, cette couche 5B et la couche sous-jacente 5A par des moyens traditionnels de gravure ionique réactive, à l'aide d'un premier masque lithographique 6.

Comme on l'a déjà expliqué, il peut être avantageux, pour cette opération, d'utiliser un contre-masque (non représenté). Ce contre-masque pourra avantageusement être laissé en surface de la couche 5B pour la suite des opérations.

Comme dans le premier mode de réalisation, on dépose ensuite sur l'ensemble de la structure une couche 3 constituée d'un matériau minéral (métallique ou diélectrique). Rappelons que l'épaisseur (de préférence entre 0,1 et 1 µm) et la nature de ce matériau, ainsi que le procédé de dépôt, doivent être choisis de manière à remplir au mieux les rainures. On peut aussi employer un empilement de plusieurs couches de natures différentes.

Le masque 6 comprendra de préférence au moins une ouverture linéaire continue et fermée sur elle-même, de façon à dessiner les limites périphériques de zones destinées à constituer des détecteurs 200. La gravure de la couche 5B sera poursuivie à travers la couche 5A, de telle manière que ce motif périphérique produise une rainure débouchant en surface du substrat 1.

A l'intérieur de chaque détecteur 200, le masque 6 est essentiellement constitué de petits (devant les dimensions d'un bolomètre) motifs, pratiqués de préférence à l'aplomb des piliers de support 2A des bolomètres. De cette manière, la construction finale selon l'invention n'a aucun effet sur la structure préexistante des bolomètres, ni sur leurs performances. La gravure de la couche 5B sera menée jusqu'à déboucher sur le sommet des piliers 2A, de sorte que la couche 3 se trouve ensuite en contact mécanique avec ces piliers.

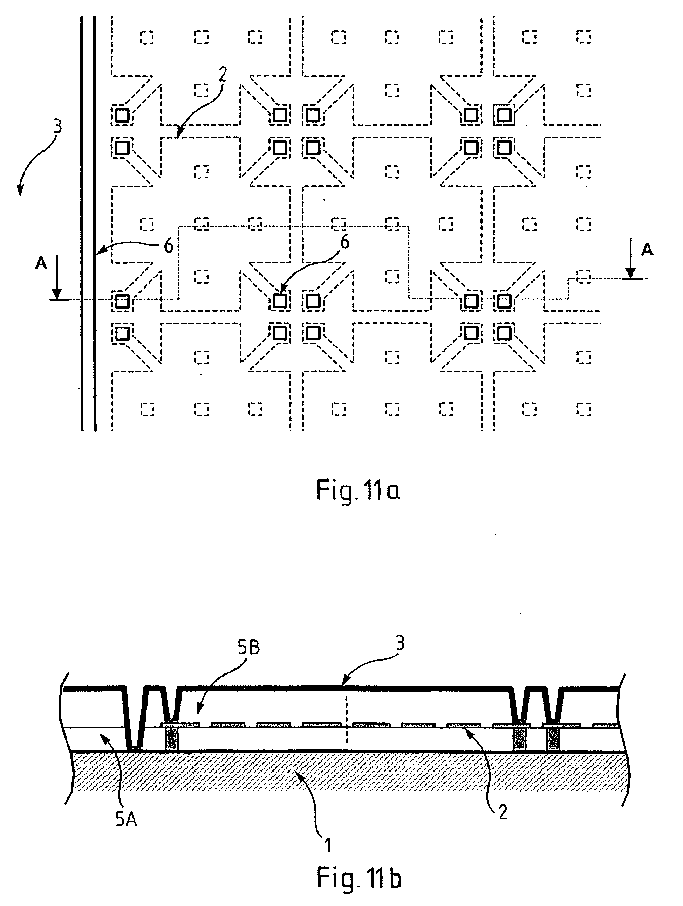

Les **figures 11a et 11b** présentent respectivement une vue de dessus et une coupe locale de l'assemblage, après élimination du masque lithographique 6 (et, le cas échéant, du contre-masque).

On passe ensuite à la troisième étape de fabrication.

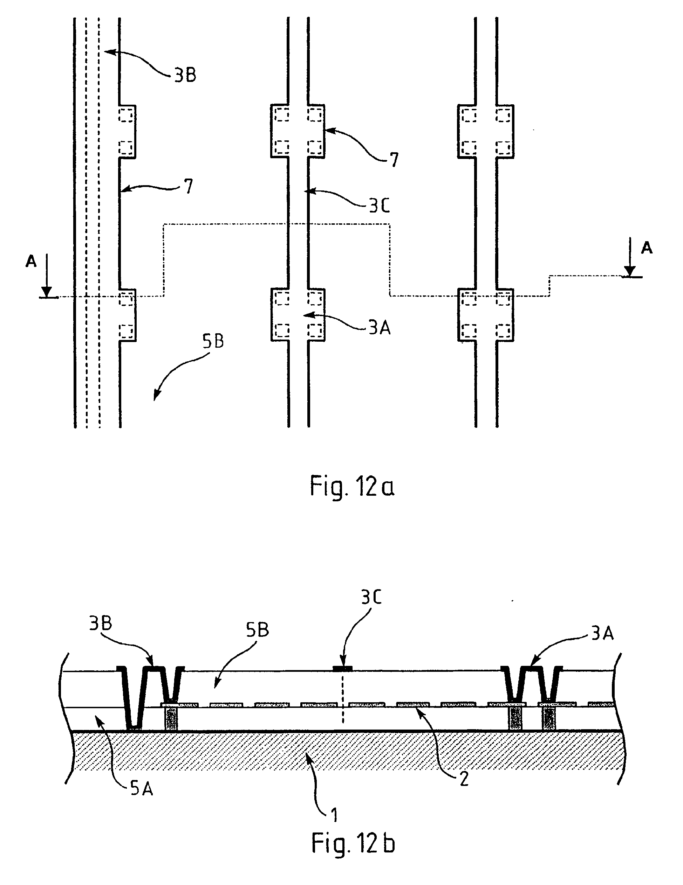

On grave d'abord la couche 3 à l'aide d'un second masque lithographique 7, suivant un contour tel que celui représenté sur la **figure 12a**.

Le motif résiduel après gravure, est constitué d'éléments 3A d'extension réduite (par rapport à la surface d'un bolomètre) dans chacun desquels est incluse au moins une ouverture 6 (voir figure 11a) pratiquée au cours de l'opération précédente, et d'éléments 3C, essentiellement étroits et plans, dont l'utilité apparaîtra plus bas. Tous les motifs du masque 7 internes au détecteur seront avantageusement disposés à l'aplomb de zones non optiquement sensibles du détecteur, comme il en existe toujours, selon par exemple la **figure 12b**. L'homme de l'art saura comment disposer au mieux les zones 3A et 3C, en fonction de la structure des microbolomètres, et adapter éventuellement cette structure pour optimiser l'ensemble. En périphérie de matrice sera dessiné un motif 3B, linéaire et continu, recouvrant le motif linéaire du masque précédent.

Au delà de la périphérie du détecteur 200, la couche 3 sera de préférence éliminée par gravure, comme représenté.

Si le contre-masque de l'étape précédente a été conservé, il en résulte un arrêt plus facile de la gravure de la couche 3 sur la couche 5B. On terminera alors cette troisième étape par la gravure auto-alignée de ce contre-masque, afin de dégager la surface de la couche 5B.

On passe ensuite à la quatrième étape de fabrication.

On dépose une troisième couche sacrificielle 5C, d'un matériau de préférence identique, ou du moins analogue à celui des couches 5A et 5B, de préférence du polyimide, qui sera également recuit de manière habituelle pour supporter la suite du processus. L'épaisseur de cette couche sera de préférence de l'ordre de 0,2 à 1 µm.

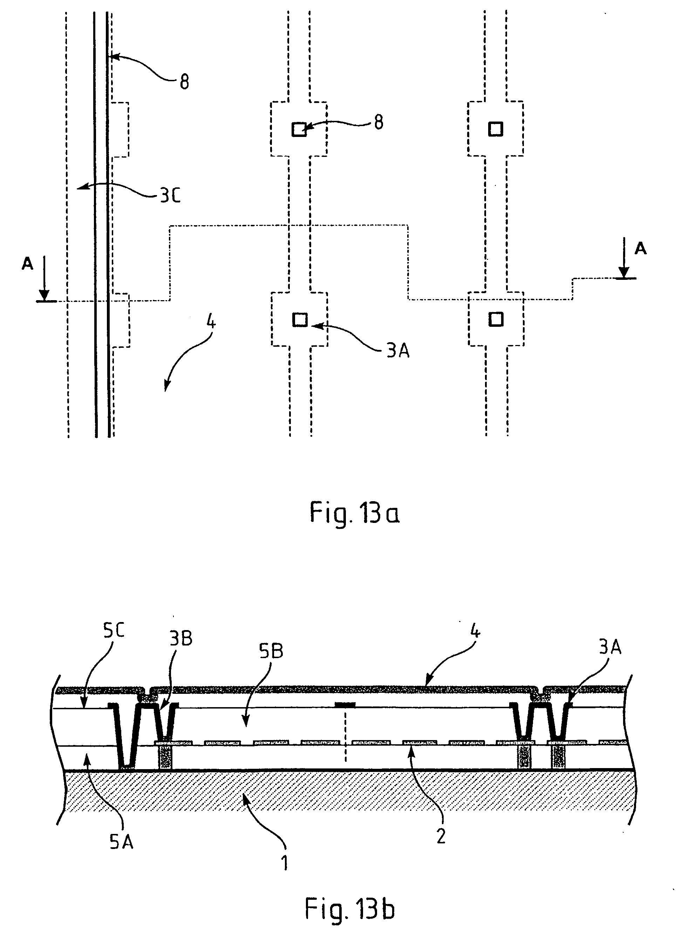

Puis l'on grave cette couche 5C par RIE à l'aide d'un troisième masque lithographique 8, dont le contour est représenté sur la **figure 13a**.

Ce masque présente de préférence des motifs d'extension réduite à l'intérieur du détecteur 200, et, pour chaque détecteur, au moins un motif périphérique, linéaire et fermé sur lui-même. Les petits motifs internes seront avantageusement disposés à l'intérieur, ou à proximité des zones 3A. Le, ou les, motifs périphériques seront aussi avantageusement disposés comme illustré sur la **figure 13b**, ou à proximité.

Après élimination du masque lithographique, on dépose une fenêtre 4 en surface de la couche 5C, comme indiqué sur la figure 13b. Les surfaces définies par le masque 8 constituent les points d'appui temporaires de la fenêtre sur la structure.

Les matières constituant la fenêtre 4 seront bien entendu choisies adéquatement, comme expliqué à propos du premier mode de réalisation de l'invention, et l'on peut ici aussi optimiser le dispositif de manière avantageuse en disposant la fenêtre 4 à une altitude idéale du point de vue ondulatoire au-dessus du plan du microbolomètre 2.

On passe ensuite à la cinquième étape de fabrication.

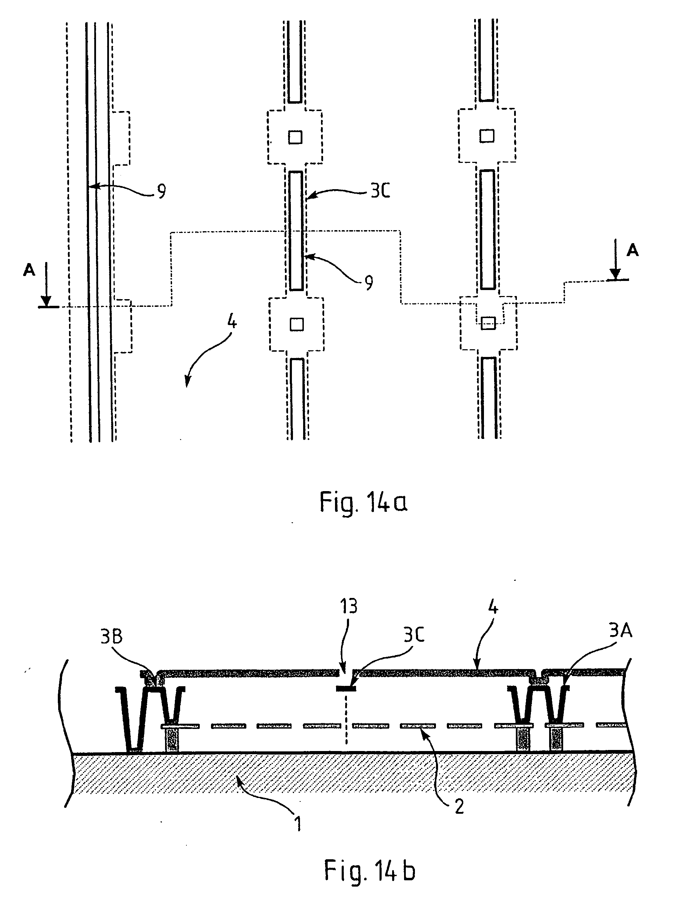

On grave la fenêtre 4 de manière connue, à l'aide d'un quatrième masque lithographique 9 représenté sur la **figure 14a**. De préférence, la fenêtre 4 ne s'étendra pas au-delà de la périphérie des détecteurs 200.

Ce masque 9 protège la fenêtre 4 sur l'essentiel de sa surface, et définit des ouvertures 13 situées de préférence au-dessus des zones 3C, comme illustré sur la **figure 14b****.**

On élimine ensuite toutes les couches sacrificielles de polyimide 5A, 5B et 5C, comme expliqué précédemment.

On notera que les zones 3B forment dorénavant des cloisons entourant le détecteur 200.

Les ouvertures 13 pratiquées précédemment à l'aide du masque 9 relient le milieu extérieur aux structures contenues dans les cavités définies entre la surface du substrat 1, les cloisons 3B et la fenêtre 4, comme le montre la figure 14b.

On passe ensuite à la sixième et dernière étape de fabrication.

On applique d'abord un traitement thermique sous vide, meilleur que 10⁻⁵ mbar de préférence, dans une enceinte adaptée, à une température aussi élevée que possible compte tenu des matériaux en place à cet instant, pendant une durée permettant le dégazage de l'ensemble des surfaces de l'assemblage : substrat, microbolomètres, cloisons, piliers, fenêtre.

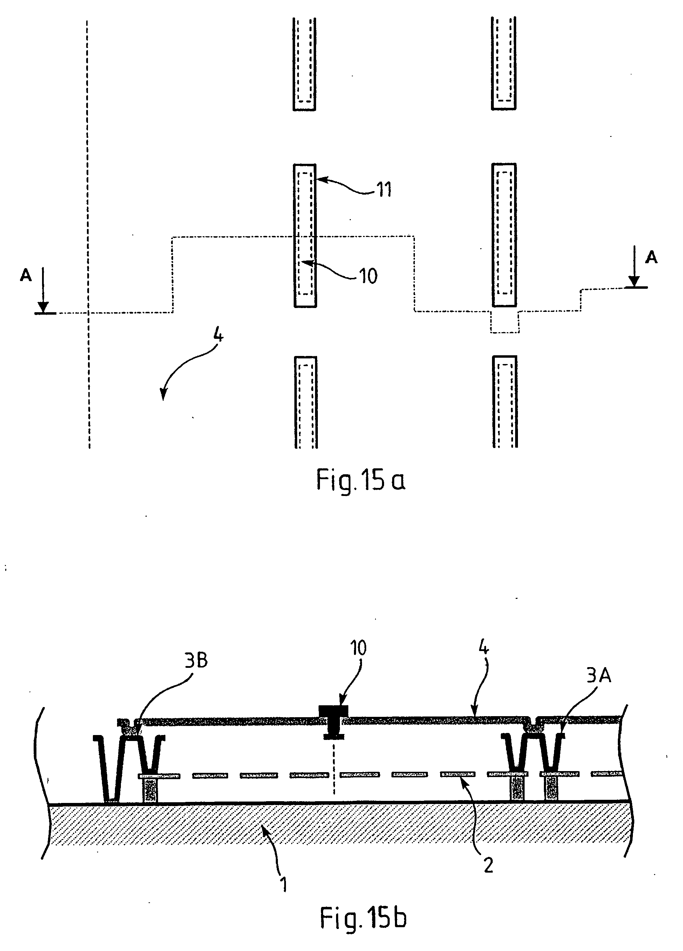

Avant remontée de pression pour retour à l'atmosphère de l'enceinte sous vide, on dépose une couche 10, de préférence métallique (par exemple en aluminium), d'épaisseur suffisante pour sceller de manière hermétique les ouvertures 13 pratiquées à l'aide du masque 9, comme le montrent les **figures 15a et 15b****.** Pour cette raison, l'espace entre la surface supérieure des motifs 3C, qui sert de support aux « bouchons », et la surface inférieure de la fenêtre 4 doit être relativement faible. Cet espace est défini par l'épaisseur de la couche 5C. L'inscription des motifs 9 à l'intérieur des motifs 3C évite la pénétration des matières métalliques à l'intérieur des cavités. Le dépôt de cette couche 10 sera réalisé de préférence par évaporation métallique.

En outre, avant remontée de pression, et avant le scellement des cavités, on pourra, comme dans le premier mode de réalisation, avantageusement introduire un gaz à faible conductivité thermique, par exemple du xénon, sous faible pression.

Les substrats peuvent alors être remis à l'atmosphère, afin de procéder à l'opération finale, alors que les cavités restent sous vide et sont protégées du milieu extérieur.

On notera ici aussi que la gamme d'épaisseurs proposée pour la fenêtre 4 (entre environ 0,1 µm et quelques µm) est suffisante pour contenir les effets de la pression atmosphérique extérieure, lorsque le processus technologique est achevé. En effet, l'appui périphérique 3B, et la densité des points d'appui 3A intérieurs aux détecteurs 200 sont tels que la déformation résultante de la fenêtre 4 entre deux points d'appui est négligeable.

On utilise enfin un cinquième masque lithographique 11 pour la gravure de la couche 10 en dehors des zones de scellement.

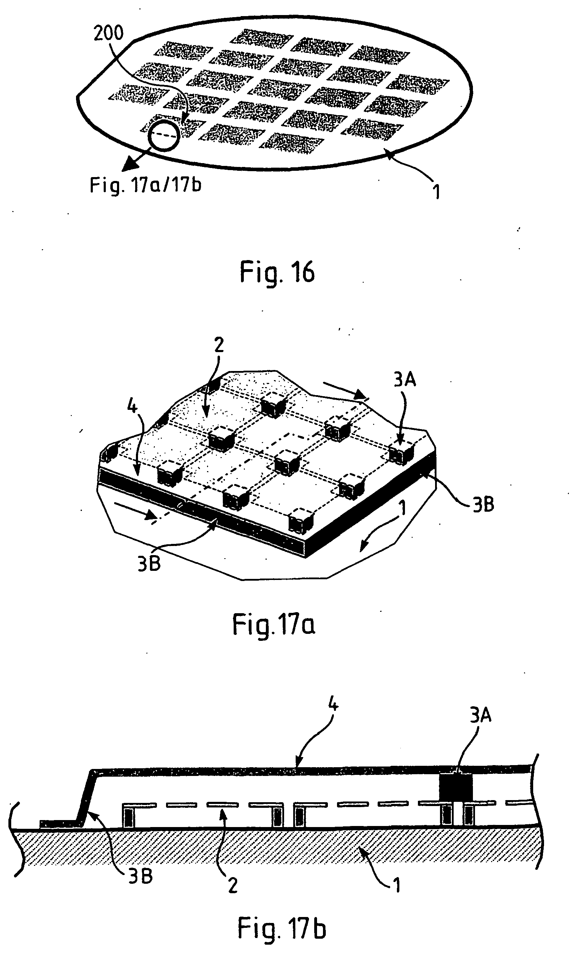

La **figure 16** représente un substrat 1 sur lequel on a construit un certain nombre de détecteurs 200 en suivant les étapes décrites ci-dessus.

La **figure 17a** est une vue en perspective d'un détecteur 200 selon l'invention, représentant un bord du détecteur, de manière à illustrer entre autres la structure correspondante. La **figure 17b** est une coupe selon la ligne en tirets de la figure 17a, prise selon un plan brisé perpendiculaire au substrat 1.

Les éléments 3A forment un réseau dense de piliers, essentiellement perpendiculaires au substrat 1. Ces piliers 3A reposent sur le substrat 1, directement, ou indirectement comme représenté sur la figure 17b.

La fenêtre 4 s'appuie sur les piliers 3A dans la partie interne du détecteur 200, ainsi que sur la cloison périphérique 3B dont elle est solidaire. Cette cloison 3B sera, de façon générale, constituée d'un ou plusieurs éléments empilés dans le sens perpendiculaire au substrat et solidaires entre eux. Le volume compris entre le substrat 1, la cloison périphérique 3B et la fenêtre 4 est isolé de manière hermétique du milieu extérieur.

Comme dans le premier mode de réalisation de l'invention, on pourra améliorer si nécessaire la durabilité du vide intérieur en prévoyant de couvrir certaines surfaces internes des cavités au moyen d'un getter classique 12 déposé par des moyens conventionnels.

On pourra par exemple, lors de la réalisation des microbolomètres, couvrir d'une telle matière une partie de la surface du substrat 1, à l'intérieur de la cavité et au voisinage immédiat de certains au moins des microbolomètres (2). Si cette disposition est susceptible de perturber les caractéristiques de qualité (optiques en particulier) des bolomètres, on disposera de préférence ces surfaces sur des zones partiellement ou totalement inactives optiquement, par exemple près des bras d'isolation thermique des bolomètres, ou sur les espaces qui séparent les bolomètres entre eux.

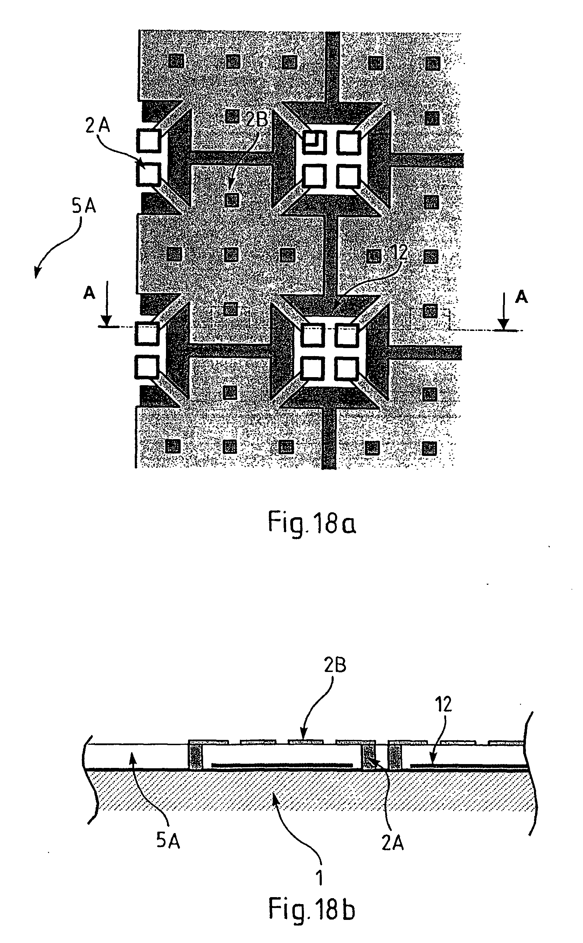

Une deuxième variante, illustrée sur les **figures 18a et 18b****,** consiste à disposer ces getters sur la quasi-totalité de la surface du substrat incluse dans chaque cavité. On a vu que cette disposition est notamment avantageuse quand le coefficient de réflexion de ces éléments dans l'infrarouge est élevé.

Une troisième variante, illustrée schématiquement sur la **figure 19**, consiste en la disposition de getters sur une partie au moins des piliers 3A, et/ou de la cloison 3B et/ou des éléments 3C. Comme on l'a expliqué, cette disposition permet de dissocier la fonction « réflecteur » de la fonction « getter », c'est-à-dire de les optimiser séparément. Selon cette disposition, la cloison périphérique 3B est constituée d'une première couche de getter, qui viendra tapisser les surfaces verticales et horizontales, puis éventuellement d'autres couches finales destinées à améliorer la géométrie, ou la résistance mécanique, ou l'étanchéité des cloisons, ou plusieurs de ces caractères simultanément.

Comme il a été expliqué en introduction, quand la fabrication des détecteurs (100, 200) selon l'un des modes de réalisation de l'invention décrits ci-dessus, ou selon un autre mode conforme aux revendications annexées, est achevée, on fait subir au substrat les opérations de tri des circuits, puis de découpe, nettoyage, et le cas échéant intégration dans des boîtiers simplifiés.

Dans la description ci-dessus, on a fait référence à des bolomètres pour fixer les idées, mais il est clair que les détecteurs concernés par l'invention peuvent être de multiples natures, et pas seulement des bolomètres, que la gamme de longueurs d'onde qu'ils peuvent détecter ne se limite nullement à l'infrarouge, et que les applications de ces détecteurs concernent de multiples domaines (par exemple, la spectroscopie), et pas seulement l'imagerie. On pourra notamment faire bénéficier de l'invention, dans ses divers aspects, tous les détecteurs de rayonnement nécessitant la mise sous vide de structures de « grandes » dimensions, telles que les MEMS (initiales des mots anglais *« Micro-Electro-Mechanical Systems »,* c'est-à-dire « Systèmes Electro-mécaniques Microscopiques »).

## Revendications

1. Procédé de fabrication de détecteurs de rayonnement, dans lequel ces détecteurs comprennent chacun un assemblage de microdétecteurs sous une fenêtre transparente audit rayonnement, **caractérisé en ce que** lesdits détecteurs sont fabriqués collectivement sur un substrat (1), et **en ce qu'**il comprend notamment les étapes suivantes dans cet ordre :
- la construction, par dépôt sur ledit substrat, de plusieurs couches dont, pour chacun desdits détecteurs, au moins une couche (4) transparente audit rayonnement et servant de fenêtre, et
- l'élimination partielle desdites couches principalement sous ladite couche transparente (4), de sorte que lesdits microdétecteurs (2) se retrouvent placés, pour chacun desdits détecteurs, dans une ou plusieurs cavités, qui sont ensuite mises sous vide ou sous faible pression.

2. Procédé de fabrication selon la revendication 1, **caractérisé en ce que** lesdites étapes de construction et d'élimination partielle de couches conduisent à la formation d'une cloison périphérique (3B) entourant chacun desdits détecteurs.

3. Procédé de fabrication selon la revendication 1 ou la revendication 2, **caractérisé en ce que** ladite étape d'élimination partielle de couches est effectuée au travers d'une ou plusieurs ouvertures (13) pratiquées dans l'enveloppe de chacun desdits détecteurs.

4. Procédé de fabrication selon la revendication 3, **caractérisé en ce que**, pour une ou toutes lesdites cavités, lesdites ouvertures (13) sont pratiquées dans ladite couche transparente (4).

5. Procédé de fabrication selon la revendication 3 ou la revendication 4, **caractérisé en ce que** ladite étape consistant à mettre lesdites cavités sous vide ou sous faible pression est effectuée au travers desdites ouvertures (13), et **en ce qu'**il a été élaboré à l'intérieur des cavités, au cours desdites étapes de construction et d'élimination partielle de couches, en regard de chacune desdites ouvertures (13), une surface (3B, 3D ; 3C) servant de support à un matériau (10) apte à boucher lesdites ouvertures (13) afin de sceller lesdites cavités.

6. Procédé de fabrication selon la revendication 1, **caractérisé en ce qu'**au moins un détecteur comprend une cloison périphérique (3B) ainsi qu'un réseau de cloisons internes (3D), ladite fenêtre (4) étant solidaire de ladite cloison périphérique (3B) et dudit réseau de cloisons internes (3D).

7. Procédé de fabrication selon la revendication 1, **caractérisé en ce qu'a**u moins un détecteur comprend une cloison périphérique (3B) ainsi qu'un réseau de piliers internes (3A), ladite fenêtre (4) étant solidaire de ladite cloison périphérique (3B) et dudit réseau de piliers internes (3A).

8. Procédé de fabrication selon l'une des revendications 1 à 7, **caractérisé en ce que** certaines surfaces internes choisies desdites cavités sont couvertes au moyen d'un getter (12).

9. Procédé de fabrication selon la revendication 8, **caractérisé en ce que** lesdites surfaces internes choisies consistent en une partie de la surface du substrat (1), au voisinage immédiat de certains au moins des microdétecteurs (2).

10. Procédé de fabrication selon la revendication 8, **caractérisé en ce que** lesdites surfaces internes choisies consistent en la quasi-totalité de la surface du substrat (1) incluse dans chaque cavité.

11. Procédé de fabrication selon la revendication 6, **caractérisé en ce que** l'on couvre au moyen d'un getter (12) une partie au moins desdites cloisons (3D, 3B).

12. Procédé de fabrication selon la revendication 7, **caractérisé en ce que** l'on couvre au moyen d'un getter (12) une partie au moins desdits piliers internes (3A) et/ou de ladite cloison périphérique (3B).

## Claims

1. A method of manufacture of radiation detectors, in which the detectors each comprise an assembly of microdetectors under a window that is transparent to said radiation, **characterized in that** said detectors are manufactured collectively on a substrate (1), and **in that** it comprises notably the following steps in this order:
- the construction, by depositing on said substrate, of several layers, of which, for each of said detectors, at least one layer (4) is transparent to said radiation and serves as a window, and
- the partial elimination of said layers principally under said transparent layer (4), such that said microdetectors (2) are placed, for each of said detectors, in one or more cavities, which are then placed under vacuum or under low pressure.

2. A method of manufacture according to Claim 1, **characterized in that** said steps of construction and partial elimination of layers leads to the formation of a peripheral partition (3B) surrounding each of said detectors.

3. A method of manufacture according to Claim 1 or Claim 2, **characterized in that** said step of partial elimination of layers is carried out through one or more openings (13) formed in the envelope of each of said detectors.

4. A method of manufacture according to Claim 3, **characterized in that**, for one or all said cavities, said openings (13) are formed in said transparent layer (4).

5. A method of manufacture according to Claim 3 or Claim 4, **characterized in that** said step consisting of creating a vacuum or a low pressure in the cavities is carried out through said openings (13), and **in that**, during said steps of construction and partial elimination of layers, a surface (3B, 3D ; 3C) has been formed within the cavities, opposite each of said openings (13), serving as a support for a material (10) capable of sealing said openings (13) in order to seal said cavities.

6. A method of manufacture according to Claim 1, **characterized in that** at least one detector comprises a peripheral partition (3B) as well as a network of internal partitions (3D), said window (4) being joined to said peripheral partition (3B) and to said network of internal partitions (3D).

7. A method of manufacture according to Claim 1, **characterized in that** at least one detector comprises a peripheral partition (3B) as well as a network of internal pillars (3A), said window (4) being joined to said peripheral partition (3B) and to said network of internal pillars (3A).

8. A method of manufacture according to one of Claims 1 to 7, **characterized in that** some selected internal surfaces of said cavities are covered with a getter (12).

9. A method of manufacture according to Claim 8, **characterized in that** said selected internal surfaces consist in a part of the surface of the substrate (1), in the immediate neighborhood of at least some of the microbolometers (2).

10. A method of manufacture according to Claim 8, **characterized in that** said selected internal surfaces consist in virtually the entire surface of the substrate (1) included in each cavity.

11. A method of manufacture according to Claim 6, **characterized in that** at least a part of said partitions (3D, 3B) is covered with a getter (12).

12. A method of manufacture according to Claim 7, **characterized in that** at least a part of said internal pillars (3A) and/or said peripheral partition (3B) is/are covered with a getter (12).

## Patentansprüche

1. Verfahren zur Herstellung von Strahlungsdetektoren, bei dem die Detektoren jeweils eine Baugruppe von Mikrodetektoren unter einem für die Strahlung transparenten Fenster umfassen, **dadurch gekennzeichnet, dass** die Detektoren kollektiv auf einem Substrat (1) hergestellt werden und dass es insbesondere die folgenden Schritte in dieser Reihenfolge umfasst:
- Herstellung von mehreren Schichten durch Auftragung auf das Substrat, darunter bei jedem der Detektoren mindestens eine für die Strahlung transparente und als Fenster dienende Schicht (4), und
- partielle Entfernung dieser Schichten hauptsächlich unter der transparenten Schicht (4), so dass die Mikrodetektoren (2) bei jedem der Detektoren in einem oder mehreren Hohlräumen angeordnet sind, die dann unter Vakuum oder unter niedrigen Druck gesetzt werden.

2. Herstellungsverfahren nach Anspruch 1**, dadurch gekennzeichnet, dass** diese Schritte der Herstellung und der partiellen Entfernung von Schichten zur Bildung einer Umfangswand (3B) führen, die jeden der Detektoren umgibt.

3. Herstellungsverfahren nach Anspruch 1 oder Anspruch 2, **dadurch gekennzeichnet, dass** der Schritt der partiellen Entfernung von Schichten durch eine oder mehrere in der Hülle jedes der Detektoren vorgesehene Öffnungen (13) hindurch vorgenommen wird.

4. Herstellungsverfahren nach Anspruch 3, **dadurch gekennzeichnet, dass** die Öffnungen (13) bei einem oder allen Hohlräumen in der transparenten Schicht (4) vorgesehen werden.

5. Herstellungsverfahren nach Anspruch 3 oder Anspruch 4, **dadurch gekennzeichnet, dass** der Schritt, der darin besteht, dass die Hohlräume unter Vakuum oder unter niedrigen Druck gesetzt werden, durch die Öffnungen (13) hindurch vorgenommen wird und dass im Inneren der Hohlräume während der Schritte der Herstellung und der partiellen Entfernung von Schichten gegenüber jeder der Öffnungen (13) eine Fläche (3B, 3D; 3C) hergestellt wurde, die als Träger für ein Material (10) dient, das die Öffnungen (13) verschließen kann, um die Hohlräume zu versiegeln.

6. Herstellungsverfahren nach Anspruch 1, **dadurch gekennzeichnet, dass** mindestens ein Detektor eine Umfangswand (3B) sowie ein Netz von inneren Trennwänden (3D) umfasst, wobei das Fenster (4) mit der Umfangswand (3B) und mit dem Netz von inneren Trennwänden (3D) fest verbunden ist.

7. Herstellungsverfahren nach Anspruch 1, **dadurch gekennzeichnet, dass** mindestens ein Detektor eine Umfangswand (3B) sowie ein Netz von inneren Säulen (3A) umfasst, wobei das Fenster (4) mit der Umfangswand (3B) und mit dem Netz von inneren Säulen (3A) fest verbunden ist.

8. Herstellungsverfahren nach einem der Ansprüche 1 bis 7, **dadurch gekennzeichnet, dass** manche ausgewählten Innenflächen der Hohlräume mit einem Getter (12) bedeckt sind.

9. Herstellungsverfahren nach Anspruch 8, **dadurch gekennzeichnet, dass** die ausgewählten Innenflächen aus einem Teil der Oberfläche des Substrats (1) in unmittelbarer Nähe von mindestens manchen der Mikrodetektoren (2) bestehen.

10. Herstellungsverfahren nach Anspruch 8, **dadurch gekennzeichnet, dass** die ausgewählten Innenflächen fast aus der Gesamtheit der in jeden Hohlraum eingeschlossenen Oberfläche des Substrats (1) bestehen.

11. Herstellungsverfahren nach Anspruch 6, **dadurch gekennzeichnet, dass** man mindestens einen Teil der Trennwände (3D, 3B) mit einem Getter (12) bedeckt.

12. Herstellungsverfahren nach Anspruch 7, **dadurch gekennzeichnet, dass** man mindestens einen Teil der inneren Säulen (3A) und/oder der Umfangswand (3B) mit einem Getter (12) bedeckt.
